# EUROPÄISCHE PATENTSCHRIFT

(11) **EP 3 229 040 B1**
(45) Veröffentlichungstag und Bekanntmachung des Hinweises auf die Patenterteilung: **12.06.2019**
(21) Anmeldenummer: 17164787.8
(22) Anmeldetag: 04.04.2017
(51) Int. Cl.: G01S 7/497, G01S 17/42, G11C 29/08, G11C 29/56

(54) **OPTOELEKTRONISCHER SENSOR MIT EINEM MESSDATENSPEICHER UND SPEICHERTESTVERFAHREN**
OPTOELECTRONIC SENSOR WITH A MEASUREMENT DATA STORAGE DEVICE AND STORAGE DEVICE TEST METHOD
CAPTEUR OPTOÉLECTRONIQUE COMPRENANT UNE MÉMOIRE DE DONNÉES DE MESURE ET PROCÉDÉ DE TEST DE MÉMOIRE

(30) Priorität: 08.04.2016 DE 102016106417
(43) Veröffentlichungstag der Anmeldung: 11.10.2017
(73) Patentinhaber: Sick AG, 79183 Waldkirch (DE)
(72) Erfinder: Schopp, Thomas, 79112 Freiburg (DE)

(56) Entgegenhaltungen:
- DE-B3-102007 008 806
- US-A1- 2015 377 964

## Beschreibung

Die Erfindung betrifft einen optoelektronischen Sensor mit einem Messdatenspeicher, insbesondere einen Laserscanner, und ein Speichertestverfahren nach dem Oberbegriff von Anspruch 1 beziehungsweise 11.

In einem Laserscanner überstreicht ein von einem Laser erzeugter Lichtstrahl mit Hilfe einer Ablenkeinheit periodisch einen Überwachungsbereich. Das Licht wird an Objekten in dem Überwachungsbereich remittiert und in dem Scanner ausgewertet. Aus der Winkelstellung der Ablenkeinheit wird auf die Winkellage des Objektes und aus der Lichtlaufzeit unter Verwendung der Lichtgeschwindigkeit zusätzlich auf die Entfernung des Objektes von dem Laserscanner geschlossen. Mit den Winkel- und Entfernungsangaben ist der Ort eines Objektes in dem Überwachungsbereich in zweidimensionalen Polarkoordinaten erfasst. Damit lassen sich die Positionen von Objekten ermitteln oder deren Kontur bestimmen.

Laserscanner werden nicht nur für allgemeine Messaufgaben, sondern auch in der Sicherheitstechnik zur Überwachung einer Gefahrenquelle eingesetzt, wie sie beispielsweise eine gefährliche Maschine darstellt. Ein derartiger Sicherheitslaserscanner ist aus der DE 43 40 756 A1 bekannt. Dabei wird ein Schutzfeld überwacht, das während des Betriebs der Maschine vom Bedienpersonal nicht betreten werden darf. Erkennt der Laserscanner einen unzulässigen Schutzfeldeingriff, etwa ein Bein einer Bedienperson, so löst er einen Nothalt der Maschine aus. Sicherheitslaserscanner müssen besonders zuverlässig arbeiten und deshalb hohe Sicherheitsanforderungen erfüllen, beispielsweise die Norm EN13849 für Maschinensicherheit und die Gerätenorm EN61496 für berührungslos wirkende Schutzeinrichtungen (BWS). Zur Erfüllung dieser Sicherheitsnormen sind eine Reihe von Maßnahmen zu treffen, wie sichere elektronisehe Auswertung durch redundante, diversitäre Elektronik, Funktionsüberwachung oder speziell Überwachung der Verschmutzung optischer Bauteile, insbesondere einer Frontscheibe.

Nun gibt es auch Anwendungen, die eine sichere Datenverarbeitung fordern, beispielsweise für einen der höheren SIL (Safety Integrity Level, vgl. EN 61508), in denen aber bereits ein nicht in diesem Sinne sicherer Laserscanner verbaut ist, oder für die ein dedizierter Sicherheitsscanner zu teuer oder beispielsweise in seiner Reichweite zu stark beschränkt wäre. Das ist dann ein Problem, weil die Daten innerhalb des Geräts und insbesondere in dessen verschiedenen RAM-Speichern nicht geprüft werden.

Es sind zwar prinzipiell Sicherungsmechanismen wie CRC (Cyclic Redundancy Check) bekannt. Das nutzt beispielsweise die US 8 321 774 B2 für eine fehlersichere Übertragung von Daten zwischen einem Sender und einem Empfänger, wobei der Sender ein Laserscanner sein kann, der über einen sicheren Feldbus kommuniziert. Das betrifft also nicht die Prüfung von Speicherbereichen in dem Laserscanner. Ohnehin ist CRC sehr rechenintensiv, vor allem bei hohen Datenraten und hohem Datenvolumen. Damit erfordert CRC erheblichen Aufwand in Software und möglicherweise sogar Hardware. In Systemen, in denen eine solche Sicherungsmaßnahme nicht vorgesehen war, ist die nachträgliche Implementierung ausgesprochen aufwändig. Es sind Änderungen oder zusätzliche Softwarebausteine im Zielsystem der Daten erforderlich, um die CRC zu berechnen und zu kontrollieren. Auch diese Software in sich könnte Fehler bergen.

Es ist an sich bekannt, Speicher durch Schreiben eines Testmusters und anschließendes Zurücklesen zu testen, etwa aus der US 6 934 205 B1. Dabei ist unter anderem eine Invertierung des vorherigen Inhalts oder ein Beschreiben mit Testmustern wie 55ₕₑₓ oder AAₕₑₓ vorgesehen. Ein solches Verfahren in einem Laserscanner zu implementieren erfordert aber ähnlich wie bei CRC einen hohen Aufwand, und außerdem werden zur Laufzeit lange Testzyklen zum Beschreiben und Auslesen jedes zu testenden Speicherbereichs benötigt.

Die US 2015/0377964 A1 offenbart einen Bildsensor mit einer Pixelmatrix, der für einen normalen Modus und einen Testmodus ausgebildet ist. In dem normalen Modus werden die Pixel auf eine Reset-Spannung aufgeladen, dann gemäß einer Belichtung entladen und ausgelesen. In dem Testmodus werden die Pixel stattdessen mit vorgegebenen Spannungen verbunden, so dass diesen vorgegebenen Spannungen entsprechende Testmuster ausgelesen werden.

Aus der DE 10 2007 008 806 B3 ist ein Sensor mit einem Bildsensor bekannt, der über ein Lichtlaufzeitverfahren Entfernungen misst. Eine Testeinheit kann den Bildsensor mit einer Zusatzbeleuchtung aus einer bekannten Entfernung blenden, und für einen erfolgreichen Test muss dabei die bekannte Entfernung gemessen werden.

Es ist deshalb Aufgabe der Erfindung, für eine Absicherung der Messdaten in einem optoelektronischen Sensor zu sorgen.

Diese Aufgabe wird durch einen optoelektronischen Sensor mit einem Messdatenspeicher und ein Speichertestverfahren nach Anspruch 1 beziehungsweise 11 gelöst. In
dem Messdatenspeicher werden die von dem Sensor erfassten Messdaten gespeichert oder zwischengespeichert. Um sicherzustellen, dass wirklich die erfassten Messdaten verarbeitet oder weitergegeben werden, wird der Messdatenspeicher einem Funktionstest unterzogen. Die Erfindung geht nun von dem Grundgedanken aus, die Messdaten für den Funktionstest durch Testdaten zu ersetzen. Die währenddessen erhaltenen Messdaten werden verworfen und dazu überschrieben oder gar nicht erst gespeichert. Anders als bei den herkömmlichen Verfahren wie CRC oder Schreiben/Zurücklesen wird also nicht nach einem Zeitfenster gesucht, in dem getestet und nicht gemessen wird. Ein geeignetes Zeitfenster würde man bei einem periodisch messenden System wie einem Laserscanner, vor allem wenn dieser nicht für Speichertests ausgelegt war, gar nicht finden.

Die Erfindung hat den Vorteil, dass Speicherfehler oder eingefrorene Daten, wie nicht korrekt abgelegte beziehungsweise ausgelesene oder eingefrorene Bits, zuverlässig erkannt werden. Das gelingt anders als etwa bei CRC ohne größeren Rechenaufwand. Es ist auch keine Sonderbehandlung der Testdaten erforderlich, sie werden behandelt wie die Messdaten, die sie ersetzen. Deshalb bedeutet es auch einen nur minimalen Aufwand, einen Sensor nachzurüsten, der zuvor gar keinen Funktionstest zum Aufdecken von Speicherfehlern vorgesehen hat.

Der Messdatenspeicher ist erfindungsgemäß Teil einer Verarbeitungskette für Messdaten des Sensors. In dieser Verarbeitungskette erfolgen Speicherzugriffe, beispielsweise um Messdaten zu sammeln und nachgelagerten Prozessen zur Verfügung zu stellen. Die Steuerung des Sensors kann als Teil der Verarbeitungskette aufgefasst werden oder mit dieser überlappen.

Die Verarbeitungskette weist bevorzugt weitere Speicher und/oder mindestens eine Verarbeitungseinheit auf. Eine Verarbeitungseinheit kann beispielsweise ein Mikroprozessor, ein FPGA (Field Programmable Gate Array) oder ein ähnlicher Baustein sein. In der Verarbeitungskette werden die Messdaten unter Umständen mehrfach ausgelesen und erneut in dem Messdatenspeicher oder in anderen Speicherbereichen abgelegt. Der erfindungsgemäße Funktionstest stellt sicher, dass dabei das Ergebnis der Verarbeitungskette nicht durch Speicherfehler verfälscht wird.

Die Steuerung ist bevorzugt dafür ausgebildet, am Ende der Verarbeitungskette das Vorliegen eines erwarteten Verarbeitungsergebnisses der Testdaten zu prüfen. Damit werden nicht nur sämtliche beteiligten Speicher in der Verarbeitungskette getestet, sondern auch die Verarbeitungskette selbst wird in einem impliziten System- oder Ablauftest überprüft. Denn das erwartete Verarbeitungsergebnis wird nur vorliegen, wenn weder Speicher noch Verarbeitungseinheiten fehlerhaft arbeiten. Das gilt zumindest für Einzelfehler. Es ist prinzipiell denkbar, zur Aufdeckung von einander zufällig kompensierenden Mehrfachfehlern innerhalb der Verarbeitungskette zusätzliche Vergleiche mit erwarteten Zwischenergebnissen durchzuführen. Das ist aber eine extrem hohe Sicherheitsanforderung, die sich selten stellt, und es erfordert tiefere Eingriffe in die Verarbeitungskette. Ein großer Vorteil eines Tests an deren Ende ist, dass die Verarbeitungskette selbst gegenüber der reinen Messwertverarbeitung unverändert bleiben kann.

Die Verarbeitungskette verändert vorzugsweise die Messdaten nicht. Das gilt dann auch für die Testdaten, da die Verarbeitungskette vorzugsweise Messdaten und Testdaten völlig gleich behandelt und gar nicht weiß, von welcher Art die jeweils verarbeiteten Daten sind. Die Messdaten nicht zu verändern bedeutet, dass am Ende der Verarbeitungskette die Messdaten vorliegen, die anfangs in den Messdatenspeicher geschrieben wurden. Das hat den Vorteil, dass auch die Testdaten unverändert bleiben und direkt damit verglichen werden kann. Obwohl die Messdaten inhaltlich erhalten bleiben, werden sie natürlich bearbeitet, beispielsweise kopiert, transportiert, zusammengefasst und dergleichen, denn sonst gäbe es keine Verarbeitungskette. Es gibt aber in dieser Ausführungsform nichts, das die Messdaten selbst ändert, wie beispielsweise ein Glättungsfilter. Alternativ berechnet man die Auswirkungen solcher Maßnahmen wie einer Glättung auf das Testmuster und vergleicht dann damit. Das hat aber den Nachteil, dass nicht mehr klar ist, ob das anfängliche Testmuster tatsächlich für einen Test gut geeignet ist und nicht beispielsweise in Daten mit zahlreichen gleichen Bits gewandelt wird, die einen verlässlichen Test erschweren.

Der Sensor weist bevorzugt einen Ausgang auf, um dort die Messdaten auszugeben, wobei an dem Ausgang eine Auswertungseinheit angeschlossen ist, die das Vorliegen eines erwarteten Verarbeitungsergebnisses der Testdaten prüft. Das ist eine Ergänzung oder Alternative dazu, dass die Testdaten intern durch die Steuerung geprüft werden. Die Auswertungseinheit ist beispielsweise eine Steuerung oder ein Host-Rechner. Dort ist eine vollständige Kontrolle des Sensors möglich, und zusätzlich werden auch noch Übertragungsfehler aufgedeckt, weil dann das Testmuster nicht in der erwarteten Form ankommt. Vorzugsweise ist die Auswertungseinheit eine sichere Auswertungseinheit im Sinne einschlägiger Normen.

Der Sensor ist bevorzugt als Laserscanner ausgebildet, wobei jeweils ein Messdatensatz das Ergebnis jeweils einer Abtastung des Überwachungsbereichs des Laserscanners ist. Laserscanner tasten periodisch einen Überwachungsbereich oder eine Überwachungsebene ab. Eine Abtastung oder ein Scan bedeutet das Ergebnis einer solchen Abtastperiode. In einem entfernungsmessenden Laserscanner ist dies das gemessene Profil des Überwachungsbereichs während der gerade abgeschlossenen Periode.

Die Testdaten weisen bevorzugt eine Folge von alternierenden Bitzuständen auf. Das Testmuster sollte möglichst Bitwechsel enthalten, um mehr Fehler aufzudecken. Besonders geeignet sind Testmuster, die auf 55ₕₑₓ und AAₕₑₓ aufbauen, in denen an jeder Stelle der Bitwert wechselt. Werden diese Testmuster sogar alternierend genutzt, wird jedes Bit einmal im Zustand Null und einmal im Zustand Eins getestet. Die Verwendung zweier komplementärer Testmuster ist auch ohne zahlreiche Bitwechsel innerhalb eines Musters nützlich.

Ein Testdatensatz weist bevorzugt eine identische Länge und Struktur wie ein Messdatensatz auf. Damit sind in der Verarbeitungskette keinerlei Anpassungen erforderlich, wenn Testdaten anstelle von Messdaten die Verarbeitungskette durchlaufen. Bei CRC ist das anders, dort muss das Format der Datensätze geändert werden, um die Prüfsumme anzuhängen.

Die Steuerung ersetzt bevorzugt jeweils einen vollständigen Messdatensatz mit einem Testdatensatz. Beispielsweise wird in einem Laserscanner ein ganzer Scan verworfen und durch Testdaten ersetzt. Damit wird der Speicher in der gesamten relevanten Breite getestet, und es ist sehr transparent, welche Messdaten wegen des Tests fehlen.

Erfindungsgemäß ersetzt das Testmuster nur einen Teil der Messdaten in einem Messdatensatz, wobei die Steuerung den ersetzten Teil zyklisch variiert. Es entsteht dabei ein gemeinsamer Datensatz, der Messdaten und Testdaten mischt. Da nur ein Teil des Speichers getestet wird, ist entweder der effektive Testzyklus verlängert, oder es müssen häufiger Testdaten eingeschleust werden. Dafür ist der Sensor nicht wegen verworfener Messdaten für einen ganzen Messdatensatz blind, sondern nur für einen Teilbereich. Alternativ könnte der gemeinsame Datensatz vorzugsweise gegenüber dem reinen Messdatensatz verlängert werden, damit Platz für Testmuster entsteht und keine Messdaten verworfen werden müssen.

Der Sensor ist vorzugsweise als sicherer Sensor zur Absicherung von Gefahrenbereichen im Sinne von Sicherheitsnormen ausgebildet. Beispiele für relevante Normen sind die ISO 13855 und die IEC 61496-4-3. Je nach rechtlichem Rahmen ist die entsprechende Norm eines anderen Landes oder ein Nachfolger heranzuziehen. Die erfindungsgemäße Art, den Speicher und die Verarbeitungskette zu testen, kann zumindest teilweise für die Erfüllung der Sicherheitsnormen mit sehr einfachen Maßnahmen sorgen.

Vorzugsweise ist eine Sicherheitsauswertungseinheit vorgesehen, die in den Messdaten eine sicherheitskritische Situation erkennt, wobei für eine Störausblendung gefordert ist, dass eine sicherheitskritische Situation bei n aufeinanderfolgenden Messungen und Auswertungen mindestens m, m ≤ n mal erkannt ist, und wobei der Testdatensatz als eine Erkennung gewertet wird. Viele Anwendungen kommen damit zurecht, wenn ein Messzyklus ausfällt, weil die Messdaten zugunsten der Testdaten verworfen werden. In einer sicherheitstechnischen Absicherung mit vorgegebener Ansprechzeit muss das aber nicht gegeben sein. Dafür ist dort häufig eine Störausblendung vorgesehen, bei der ein Ereignis erst dann als sicherheitskritisch eingestuft wird, wenn es in m von n Detektionen, beispielsweise Scans, erkannt wird. Dann kann der Testzyklus einfach als sicherheitskritisches Ereignis behandelt werden, also beispielsweise wie eine Schutzfeldverletzung, und damit für die Bestimmung von m mitgezählt werden. Ähnlich gehen manche Sicherheitssensoren und speziell Sicherheitslaserscanner mit aus anderen Gründen unbrauchbaren oder verlorenen Messdaten um, etwa wenn der Sensor erschüttert wurde, der Nullindex fehlte oder die Positionsinformation fehlerhaft ist. Der Test wird also als Störereignis angesehen, und so bleibt die Ansprechzeit auf jeden Fall erhalten.

Das erfindungsgemäße Verfahren hat den besonderen Vorteil, dass es relativ problemlos nachgerüstet werden kann. Es muss lediglich dafür gesorgt werden, dass in dem Messdatenspeicher zyklisch oder auf Anforderung Messdaten mit Testdaten überschrieben werden. Dann kann anhand der ausgegebenen Messdaten nach dieser Speicherung von Testdaten geprüft werden, ob der Messdatenspeicher sowie die Verarbeitungskette bis zur Ausgabe von Messdaten fehlerfrei funktioniert. Eine ausgesprochen aufwändige Veränderung in der Software oder gar der Hardware der Verarbeitungskette wie für einen CRC oder ähnliche herkömmliche Verfahren ist dagegen nicht erforderlich. Im Übrigen kann das erfindungsgemäße Verfahren in ähnlicher Weise weitergebildet werden wie der erfindungsgemäße Sensor und zeigt dabei ähnliche Vorteile. Derartige vorteilhafte Merkmale sind beispielhaft, aber nicht abschließend in den sich an die unabhängigen Ansprüche anschließenden Unteransprüchen beschrieben.

Die Erfindung wird nachstehend auch hinsichtlich weiterer Merkmale und Vorteile beispielhaft anhand von Ausführungsformen und unter Bezug auf die beigefügte Zeichnung näher erläutert. Die Abbildungen der Zeichnung zeigen in:
- Fig. 1: eine schematische Darstellung eines Laserscanners;
- Fig. 2: eine Blockdarstellung einer Verarbeitungskette für Messdaten innerhalb des Laserscanners mit einem zu testenden Speicher;
- Fig. 3: Beispiele für Messdaten und Testdaten, die in der Verarbeitungskette gespeichert und verarbeitet werden;
- Fig. 4: eine Blockdarstellung einer anderen Ausführungsform der Verarbeitungskette mit mehreren Speichern und Verarbeitungseinheiten; und
- Fig. 5: weitere Beispiele für gemischte Messdaten und Testdaten in einer erfindungsgemäßen Ausführungsform zum Testen von Speicher und Verarbeitungskette.

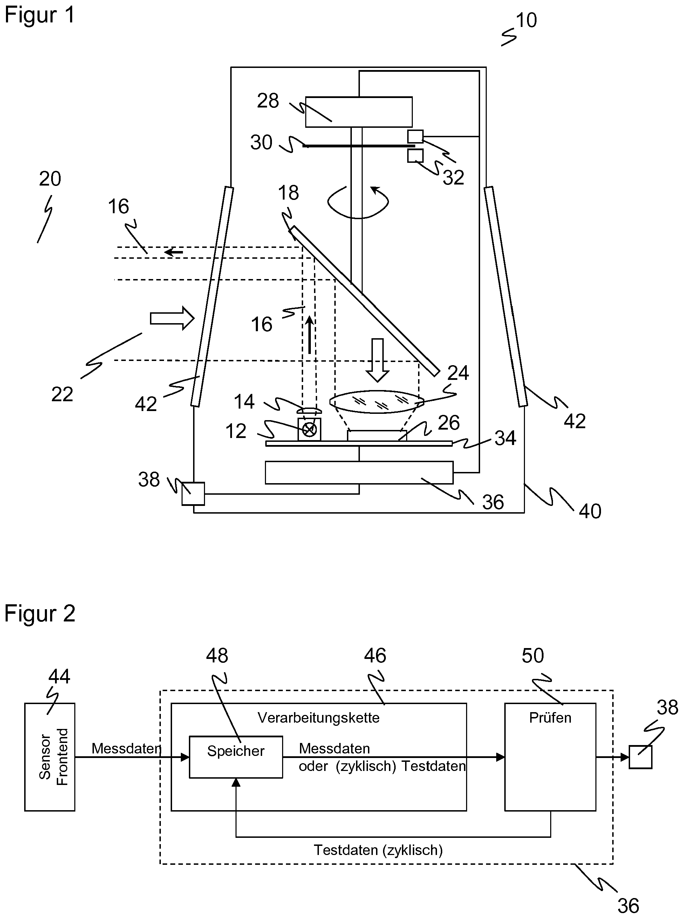

Fig. 1 zeigt eine schematische Schnittdarstellung durch einen Laserscanner 10. Die Beschreibung der Erfindung erfolgt am Beispiel eines Laserscanners 10. Die erfindungsgemäße Lösung zum Testen von Speicher beziehungsweise Verarbeitungskette der Messdaten ist aber auch für andere optoelektronische Sensoren relevant. Nicht abschließend genannte Beispiele sind Lichttaster, Kameras oder Codeleser, wenn in deren jeweiliger Anwendung eine entsprechende Verlässlichkeit im Betrieb gefordert ist.

In dem Laserscanner 10 erzeugt ein Lichtsender 12, beispielsweise mit einer Laserlichtquelle, mit Hilfe einer Sendeoptik 14 einen Sendelichtstrahl 16, der an einer Ablenkeinheit 18 in einen Überwachungsbereich 20 umgelenkt wird. Fällt der Sendelichtstrahl 16 in dem Überwachungsbereich 20 auf ein Objekt, so gelangt remittiertes Licht 22 wieder zu dem Laserscanner 10 zurück und wird dort über die Ablenkeinheit 18 und mittels einer Empfangsoptik 24 von einem Lichtempfänger 26 detektiert, beispielsweise einer Photodiode oder einer APD (Avalanche Photo Diode).

Die Ablenkeinheit 18 ist in dieser Ausführungsform als Drehspiegel ausgestaltet, die durch Antrieb eines Motors 28 kontinuierlich rotiert. Die jeweilige Winkelstellung des Motors 28 beziehungsweise der Ablenkeinheit 18 wird über einen Encoder erkannt, der beispielsweise eine Codescheibe 30 und eine Gabellichtschranke 32 umfasst. Der von dem Lichtsender 12 erzeugte Sendelichtstrahl 16 überstreicht somit den durch die Rotationsbewegung erzeugten Überwachungsbereich 20. Anstelle eines Drehspiegels ist auch möglich, die Ablenkeinheit 18 als rotierenden Optikkopf auszubilden, in dem Lichtsender 12 und/oder Lichtempfänger 26 und möglicherweise weitere Elemente untergebracht sind. Auch die Gestaltung von Sendeoptik 14 und Empfangsoptik 24 kann variiert werden, etwa über einen strahlformenden Spiegel als Ablenkeinheit, eine andere Anordnung der Linsen oder zusätzliche Linsen. Insbesondere sind Laserscanner auch in einer Autokollimationsanordnung bekannt. In der dargestellten Ausführungsform sind Lichtsender 12 und Lichtempfänger 26 auf einer gemeinsamen Leiterkarte 34 untergebracht. Auch das ist nur ein Beispiel, denn es können eigene Leiterkarten sowie andere Anordnungen beispielsweise mit einem gegenseitigen Höhenversatz vorgesehen sein.

Wird nun von dem Lichtempfänger 26 remittiertes Licht 22 aus dem Überwachungsbereich 20 empfangen, so kann aus der von dem Encoder 30, 32 gemessenen Winkelstellung der Ablenkeinheit 18 auf die Winkellage des Objektes in dem Überwachungsbereich 20 geschlossen werden. Zusätzlich wird vorzugsweise die Lichtlaufzeit von Aussenden eines Lichtsignals bis zu dessen Empfang nach Reflexion an dem Objekt in dem Überwachungsbereich 20 ermittelt und unter Verwendung der Lichtgeschwindigkeit auf die Entfernung des Objektes von dem Laserscanner 10 geschlossen.

Diese Auswertung erfolgt in einer Steuerung 36, die dafür mit dem Lichtsender 12, dem Lichtempfänger 26, dem Motor 28 und dem Encoder 32 verbunden ist. Somit stehen über den Winkel und die Entfernung zweidimensionale Polarkoordinaten aller Objekte in dem Überwachungsbereich 20 zur Verfügung. In sicherheitstechnischer Anwendung prüft die Steuerung 36 möglicherweise auch noch, ob ein unzulässiges Objekt in einen innerhalb des Überwachungsbereichs 20 festgelegten Schutzbereich eingreift, um daraufhin ein Absicherungssignal an eine überwachte Gefahrenquelle, beispielsweise eine Maschine auszugegeben. Der Laserscanner 10 ist in derartigen sicherheitstechnischen Anwendungen durch Maßnahmen entsprechend der einleitend genannten Normen ein sicherer Laserscanner.

Die durch die Abtastung jeweils erhaltenen Polarkoordinaten entsprechen einem Abtastpunkt und sind ein Beispiel für Messdaten des Laserscanners 10. Die Abtastpunkte einer Umdrehung der Ablenkeinheit 18, auch als ein Scan bezeichnet, können in jeweils einem Messdatensatz zusammengefasst werden. Messdaten werden dann an einem Ausgang 38 bereitgestellt. Alle genannten Funktionskomponenten sind in einem Gehäuse 40 angeordnet, das im Bereich des Lichtaus- und Lichteintritts eine Frontscheibe 42 aufweist.

Figur 2 illustriert in einer Blockdarstellung einen Speichertest, der sicherstellt, dass die Messdaten nicht durch Speicherfehler verfälscht werden. Der gesamte optische Pfad zwischen Lichtsender 12 und Lichtempfänger 26 ist schematisch als Sensor-Frontend 44 zusammengefasst. Von dort werden Messdaten an die Steuerung 36 geliefert und dort in einer Verarbeitungskette 46 weiterbehandelt. In diesem Beispiel besteht die Verarbeitungskette 46 sehr vereinfacht lediglich aus einem Speicher 48, in dem die Messdaten abgelegt und aus dem sie wieder ausgelesen werden. Am Ende der Verarbeitungskette 46 folgt ein Prüfabschnitt 50, der die Messdaten an den Ausgang 38 weiterleitet.

Der Prüfabschnitt 50 ersetzt zyklisch oder auf Anfrage, wann immer ein Speichertest durchgeführt werden soll, Messdaten durch Testdaten. Dabei werden die realen Messdaten verworfen, und der Speicher 48 wird stattdessen in den zu testenden Bereichen mit Testdaten gefüllt. Der Prüfabschnitt 50 erhält daraufhin am Ende der Verarbeitungskette 46 Testdaten anstelle von Messdaten. Durch Vergleich der ausgelesenen Testdaten mit den zuvor geschriebenen Testdaten in dem Prüfabschnitt 50 werden Fehler des Speichers 48 und darüber hinaus auch Fehler der Verarbeitungskette 46 aufgedeckt.

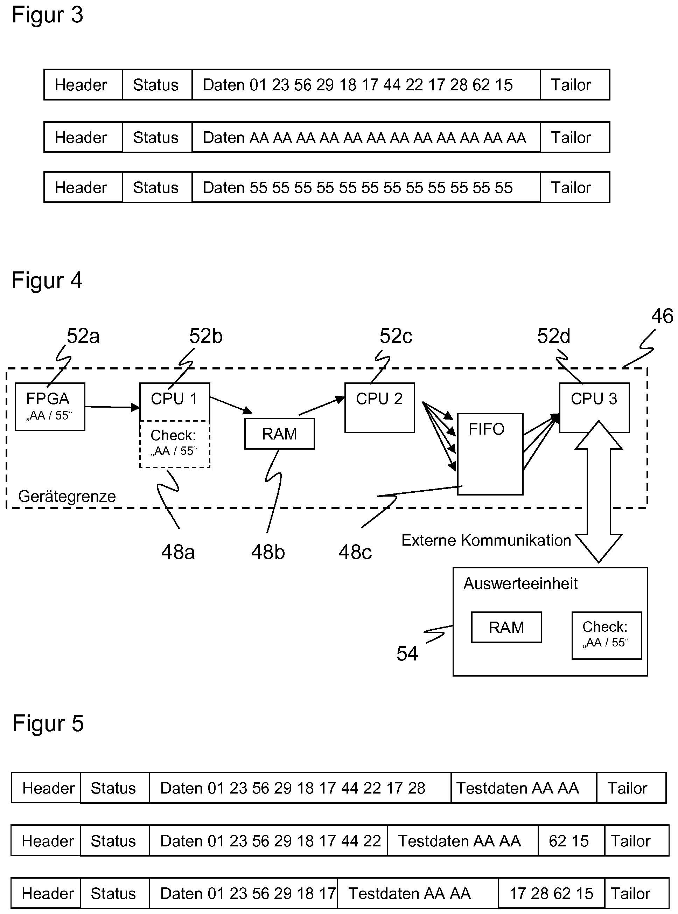

Figur 3 zeigt Beispiele von Datenpaketen. In der ersten Zeile handelt es sich um Messdaten, die hier durch zufällige Zahlenwerte repräsentiert sind. Die beiden folgenden Zeilen sind besonders geeignete Testmuster AAₕₑₓ und 55ₕₑₓ, die nämlich als Bitmuster ständige Wechsel enthalten (1010 1010 beziehungsweise 0101 0101). Es sind aber prinzipiell auch beliebige Testmuster möglich.

Speichertests durch Schreiben und Zurücklesen werden normalerweise nicht im laufenden Betrieb durchgeführt, weil der Speicher während des Tests nicht verfügbar ist und seine Daten verloren gehen. Durch das erfindungsgemäße Ersetzen von Messdaten durch Testdaten wird jeweils ein Messdatenpaket verworfen. Ist das Messdatenpaket beispielsweise ein Scan, so wird für jeden Test ein Scan verworfen. Der Speichertest stört also tatsächlich den Betrieb nur geringfügig und in einer genau definierten Weise. In den meisten Anwendungen ist der zyklische Verlust eines Scans ohne Weiteres hinnehmbar.

Manche Anwendungen sind besonders zeitkritisch, etwa die sicherheitstechnische Überwachung einer Gefahrenquelle. Dort gibt es eine aus den Sicherheitsnormen abgeleitete Ansprechzeit, die keinesfalls überschritten werden darf. Auch das ist aber mit dem Speichertest vereinbar. Typischerweise löst nämlich ein Sicherheitssensor ein sicherheitsgerichtetes Abschaltsignal nicht schon nach einem Einzelereignis aus, sondern hat vielmehr eine Störerkennung, in der sich das Ereignis in m von n, m ≤ n, Fällen bestätigen muss. Ein wiederholt von dem Laserscanner 10 angetastetes Objekt kann also eine sicherheitsgerichtete Abschaltung auslösen, ein Einzelereignis wie ein Regentropfen nicht. Andere Störungen sind beispielsweise eine kurze Erschütterung des Laserscanners 10, ein fehlender Nullindex oder dergleichen. Solche Störungen werden einfach behandelt wie Messdaten mit einem sicherheitskritischen Ereignis, werden also vorsichtshalber für die Ermittlung von m mitgezählt. Das Gleiche kann mit den Testdaten geschehen. Dann bleibt die Einhaltung der Ansprechzeit auch mit dem Speichertest gewährleistet.

Es ist vorteilhaft, wenn die Verarbeitungskette 46 Messdaten nicht durch Berechnungen, Filterungen und dergleichen verändert. Da die Verarbeitungskette 46 nicht zwischen Messdaten und Testdaten unterscheidet beziehungsweise gar keine Information darüber hat, ob sie aktuell Messdaten oder Testdaten verarbeitet, würden sonst auch die Testdaten den Veränderungen unterliegen, also beispielsweise das Testmuster AAₕₑₓ oder 55ₕₑₓ verändern. Um dennoch den Speicher zu prüfen, muss dann der Prüfabschnitt 50 Kenntnis haben, wie diese Veränderungen aussehen. Sind diese Voraussetzungen gegeben, also die Messdaten und damit Testdaten werden in der Verarbeitungskette 46 nicht verändert oder der Prüfabschnitt hat Kenntnis, wie die Verarbeitungskette 46 Testdaten verändert, so werden nicht nur Speicherfehler aufgedeckt, sondern auch Ablauffehler in der Verarbeitungskette 46.

Ein besonderer Vorteil des erfindungsgemäßen Vorgehens ist die einfache Nachrüstbarkeit eines Speichertests, wenn zuvor keiner vorgesehen war. Dazu reicht die Veränderung an nur einer Stelle in dem Laserscanner 10, nämlich um das Testmuster zu erzeugen und in den Speicher 48 zu schreiben. Die übrige Verarbeitungskette 46 kann unverändert bleiben. Im Beispiel der Figur 2 stellt der Prüfabschnitt 50 noch eine weitere Veränderung dar. Diese Prüfung kann aber alternativ auch erst nach dem Ausgang 38, also außerhalb des Laserscanners 10 erfolgen. Dann bleibt es tatsächlich bei der genannten einzigen Stelle, an der modifiziert werden muss. Nimmt man größere Modifikationen in Kauf, kann das Testmuster schon innerhalb der Verarbeitungskette 46 geprüft werden, um auch Mehrfachfehler aufzudecken, also auszuschließen, dass sich mehrere Fehler zufällig kompensieren und damit unentdeckt bleiben.

Figur 4 zeigt eine alternative Ausführungsform der Verarbeitungskette 46, die deutlich komplexer ist und mehrere Speicher 48a-c sowie mehrere Verarbeitungseinheiten 52a-d aufweist. Außerdem erfolgt die Überprüfung der Testmuster und damit die Aufdeckung von Speicherdefekten und Ablauffehlern in der Verarbeitungskette 46 nicht innerhalb der Steuerung 36 oder des Laserscanners 10, sondern extern in einer vorzugsweise sicheren Auswertungseinheit 54, beispielsweise einer Sicherheitssteuerung oder einem Host-Rechner.

In dieser Ausführungsform erfordert der Speichertest innerhalb des Laserscanners 10 lediglich eine Änderung, nämlich Erzeugen und Einschleusen des Testmusters. Daten werden von einem internen Speicher des FPGA 52a in einen internen Speicher 48a der CPU1 52b übertragen. Das ist ebenso rein beispielhaft wie der weitere Ablauf, in dem physikalisch getrennte Speicher wie ein RAM-Speicher 48b oder ein FIFO-Speicher 48c vorgesehen sind, auf die auch noch die CPU2 52c und die CPU3 52d zugreifen können.

In dem FPGA wird nun zyklisch oder auf Anfrage ein Testdatensatz erzeugt und ersetzt einen Messdatensatz. Wie schon anhand der Figur 3 erläutert, hat der Testdatensatz vorzugsweise die identische Struktur und Länge wie ein Messdatensatz. Anders als bei CRC entsteht also kein Speicheroverhead durch Anhängen einer Prüfsumme, sondern ein Messdatensatz enthält nur Nutzdaten.

Der Testdatensatz durchläuft denselben Weg in der Verarbeitungskette 46 wie ein Messdatensatz. Dadurch werden alle relevanten Bereiche abgeprüft. Die Überprüfung erfolgt erst in der Auswerteeinheit 54, also dort, wo tatsächlich eine Entscheidung auf Basis von Messdaten getroffen wird. Die Verarbeitungskette 46 selbst bleibt von dem Speichertest unberührt, vorzugsweise mit der einzigen Ausnahme an deren Anfang zum Ersetzen von Messdaten durch Testdaten.

In den bisherigen Ausführungsformen wurde jeweils wie in Figur 3 illustriert ein gesamter Messdatensatz durch einen Testdatensatz ersetzt. Erfindungsgemäß ersetzen die Testdaten jedoch nur einen Teil der Messdaten, wie in Figur 5 gezeigt. Der ersetzte Teil wandert zyklisch durch den Messdatensatz, so dass im Verlauf eines solchen Zyklus alle relevanten Speicherbereiche getestet werden. Es ist auch denkbar, den Messdatensatz um einen der Länge der Testdaten entsprechenden Block zu verlängern. Dann können Testdaten zyklisch an verschiedenen Stellen zwischengeschoben werden, ohne Messdaten zu überdecken.

## Patentansprüche

1. Optoelektronischer Sensor (10), insbesondere Laserscanner, mit mindestens einem Messdatenspeicher (48) für die Speicherung von Messdaten und mit einer Steuerung (36), die eine Verarbeitungskette (46) für Messdaten mit dem Messdatenspeicher (48) aufweist und die für einen Funktionstest des Messdatenspeichers (48) ausgebildet ist,
**dadurch gekennzeichnet,**
**dass** die Steuerung (36, 52a) weiterhin dafür ausgebildet ist, für den Funktionstest periodisch oder auf Anforderung Messdaten durch Testdaten zu ersetzen und dabei die während des Funktionstests erhaltenen Messdaten zu verwerfen, so dass es kein Zeitfenster gibt, in dem getestet und nicht gemessen wird, und dass die Testdaten nur einen Teil der Messdaten in einem Messdatensatz ersetzen, wobei die Steuerung (36, 52a) den ersetzten Teil zyklisch variiert.

2. Sensor (10) nach Anspruch 1,
wobei die Verarbeitungskette (46) weitere Speicher (48a-c) und/oder mindestens eine Verarbeitungseinheit (52a-d) aufweist.

3. Sensor (10) nach Anspruch 1 oder 2,
wobei die Steuerung (36, 50) dafür ausgebildet ist, am Ende der Verarbeitungskette (46) das Vorliegen eines erwarteten Verarbeitungsergebnisses der Testdaten zu prüfen.

4. Sensor (10) nach einem der vorhergehenden Ansprüche,
wobei die Verarbeitungskette (46) Messdaten inhaltlich nicht verändert.

5. Sensor (10) nach einem der vorhergehenden Ansprüche,
der einen Ausgang (38) aufweist, um dort die Messdaten auszugeben, wobei an dem Ausgang (38) eine Auswertungseinheit (54) anschließbar ist, die das Vorliegen eines erwarteten Verarbeitungsergebnisses der Testdaten prüft.

6. Sensor (10) nach einem der vorhergehenden Ansprüche,
der als Laserscanner ausgebildet ist, und wobei jeweils ein Messdatensatz das Ergebnis jeweils einer Abtastung des Überwachungsbereichs (20) des Laserscanners ist.

7. Sensor (10) nach einem der vorhergehenden Ansprüche,
wobei die Testdaten eine Folge von alternierenden Bitzuständen aufweisen.

8. Sensor (10) nach einem der vorhergehenden Ansprüche,
wobei ein Testdatensatz eine identische Länge und Struktur wie ein Messdatensatz aufweist.

9. Sensor (10) nach einem der vorhergehenden Ansprüche, der als sicherer Sensor zur Absicherung von Gefahrenbereichen im Sinne von Sicherheitsnormen ausgebildet ist.

10. Sensor (10) nach Anspruch 9, wobei eine Sicherheitsauswertungseinheit (36, 54) vorgesehen ist, die in den Messdaten eine sicherheitskritische Situation erkennt, und wobei für eine Störausblendung gefordert ist, dass eine sicherheitskritische Situation bei n aufeinanderfolgenden Messungen und Auswertungen mindestens m, m ≤ n mal erkannt ist, und wobei der Testdatensatz als eine Erkennung gewertet wird.

11. Speichertestverfahren für einen optoelektronischen Sensor (10), insbesondere Laserscanner, der eine Verarbeitungskette (46) für Messdaten mit mindestens einem Messdatenspeicher (48) für die Speicherung von Messdaten aufweist, **dadurch gekennzeichnet,**
**dass** für einen Funktionstest des Messdatenspeichers (48) zyklisch oder auf Anforderung während des Funktionstests erhaltene Messdaten verworfen werden und stattdessen Testdaten in dem Messdatenspeicher (48) abgelegt werden, so dass es kein Zeitfenster gibt, in dem getestet und nicht gemessen wird, und dann am Ende der Verarbeitungskette (46) geprüft wird, ob ein erwartetes Verarbeitungsergebnis der Testdaten vorliegt, und dass die Testdaten nur einen Teil der Messdaten in einem Messdatensatz ersetzen, wobei der ersetzte Teil zyklisch variiert wird.

## Claims

1. An optoelectronic sensor (10), in particular laser scanner, having at least one measurement data memory (48) for storing measurement data and having a controller (36) comprising a processing chain (46) for measurement data which includes the measurement data memory (48) and is configured for a function test of the measurement data memory (48),
**characterized in that** the controller (36, 52a) is furthermore configured to replace measurement data by test data for the function test periodically or on request and to thereby discard the measurement data obtained during the function test, so that there is no time window in which it is tested and not measured, and **in that** the test data replaces only a part of the measurement data in a measurement data set, the controller (36, 52a) cyclically varying the replaced part.

2. The sensor (10) according to claim 1,
wherein the processing chain (46) comprises additional memories (48a c) and/or at least one processing unit (52a d).

3. The sensor (10) according to claim 1 or 2,
wherein the controller (36, 50) is configured to check the presence of an expected processing result of the test data at the end of the processing chain (46).

4. The sensor (10) according to any one of the preceding claims,
wherein the processing chain (46) does not change the content of measurement data.

5. The sensor (10) according to any one of the preceding claims,
which has an output (38) for outputting the measurement data, an evaluation unit (54) being connectable to the output (38), which evaluation unit checks the presence of an expected processing result of the test data.

6. The sensor (10) according to any one of the preceding claims,
which is configured as a laser scanner, and wherein a respective measurement data set is the result of a respective scanning of the monitoring region (20) of the laser scanner.

7. The sensor (10) according to any one of the preceding claims,
wherein the test data comprise a sequence of alternating bit states.

8. The sensor (10) according to any one of the preceding claims,
wherein a test data set has an identical length and structure as a measurement data set.

9. The sensor (10) according to any one of the preceding claims,
which is configured as a safe sensor for safeguarding hazardous areas in accordance with safety standards.

10. The sensor (10) according to claim 10,
wherein a safety evaluation unit (36, 54) is provided which detects a safety-critical situation in the measurement data, and wherein for an interference suppression it is required that a safety-critical situation during n consecutive measurements and evaluations is detected at least m, m≤n n times, and wherein the test data set counts as one detection.

11. A memory test method for an optoelectronic sensor (10), in particular a laser scanner, which has a processing chain (46) for measurement data which includes at least one measurement data memory (48) for storing measurement data,
**characterized in that**, for a function test of the measurement data memory (48), measurement data obtained during the function test are discarded cyclically or upon request, and instead test data are stored in the measurement data memory (48), so that there is no time window in which it is tested and not measured, and then at the end of the processing chain (46) it is checked whether an expected processing result of the test data is present, and **in that** the test data replace only a part of the measurement data in a measurement data set, the replaced part being varied cyclically.

## Revendications

1. Capteur optoélectronique (10), en particulier scanneur laser, comportant au moins une mémoire de données de mesure (48) pour stocker des données de mesure et comportant une commande (36) qui présente une chaîne (46) de traitement des données de mesure avec la mémoire de données de mesure (48) et qui est réalisée pour un test de fonctionnement de la mémoire de données de mesure (48),
**caractérisé en ce que**
la commande (36, 52a) est en outre réalisée pour remplacer des données de mesure par des données de test périodiquement ou à la demande en vue du test de fonctionnement et pour rejeter les données de mesure obtenues pendant le test de fonctionnement, de sorte qu'il n'existe pas de fenêtre temporelle dans laquelle on procède à un test et non pas à une mesure, et que
les données de test ne remplacent qu'une partie des données de mesure dans un lot de données de mesure, la commande (36, 52a) variant cycliquement la partie remplacée.

2. Capteur (10) selon la revendication 1,
dans lequel
la chaîne de traitement (46) comprend d'autres mémoires (48a - c) et/ou au moins une unité de traitement (52a - d).

3. Capteur (10) selon la revendication 1 ou 2,
dans lequel
la commande (36, 50) est réalisée pour vérifier, à l'issue de la chaîne de traitement (46), la présence d'un résultat de traitement attendu des données de test.

4. Capteur (10) selon l'une des revendications précédentes,
dans lequel
la chaîne de traitement (46) ne modifie pas les données de mesure quant à leur contenu.

5. Capteur (10) selon l'une des revendications précédentes, comportant une sortie (38) pour émettre ici les données de mesure, une unité d'évaluation (54) pouvant être connectée à la sortie (38), qui vérifie la présence d'un résultat de traitement attendu des données de test.

6. Capteur (10) selon l'une des revendications précédentes, réalisé sous la forme d'un scanneur laser, un lot de données de mesure respectif étant le résultat d'un balayage respectif de la zone à surveiller (20) du scanneur laser.

7. Capteur (10) selon l'une des revendications précédentes,
dans lequel
les données de test présentant une succession d'états de bit alternants.

8. Capteur (10) selon l'une des revendications précédentes,
dans lequel
un lot de données de test présente une longueur et une structure identiques à celles d'un lot de données de mesure.

9. Capteur (10) selon l'une des revendications précédentes,
réalisé sous la forme d'un capteur sécurisé pour sécuriser des zones dangereuses dans le sens des normes de sécurité.

10. Capteur (10) selon la revendication 9,
dans lequel
il est prévu une unité d'évaluation de sécurité (36, 54) qui reconnaît dans les données de mesure une situation critique vis-à-vis de la sécurité, et en vue d'une suppression de perturbations, il est requis qu'une situation critique vis-à-vis de la sécurité soit reconnue au moins m fois, m ≤ n, pour n mesures et évaluations successives, et
le lot de données de test est évalué comme une reconnaissance.

11. Procédé de test de mémoire pour un capteur optoélectronique (10), en particulier un scanneur laser, présentant une chaîne (48) de traitement de données de mesure avec au moins une mémoire de données de mesure (48) pour stocker des données de mesure,
**caractérisé en ce que**
pour un test de fonctionnement de la mémoire de données de mesure (48), des données de mesure obtenues pendant le test de fonctionnement sont rejetées cycliquement ou à la demande et à leur place des données de test sont stockées dans la mémoire de données de mesure (48), de sorte qu'il n'existe pas de fenêtre temporelle dans laquelle on procède à un test et non pas à une mesure, et, à l'issue de la chaîne de traitement (46), on vérifie s'il se présente un résultat de traitement attendu des données de test, et les données de test ne remplacent qu'une partie des données de mesure dans un lot de données de mesure, la partie remplacée étant variée cycliquement.
